# EUROPEAN PATENT APPLICATION

(11) **EP 3 663 751 A1**
(43) Date of publication of application: **10.06.2020**
(21) Application number: 18211074.2
(22) Date of filing: 07.12.2018
(51) Int. Cl.: G01N 27/72, D01F 9/12, G01R 33/12, G01N 29/24

(54) **METHOD AND APPARATUS FOR ASSESSING PHYSICAL PROPERTIES OF A PARA- OR DIAMAGNETIC STRUCTURE SUCH AS A CARBON FIBER**

(71) Applicant: Universität Augsburg, 86159 Augsburg (DE)
(72) Inventor: Kalafat, Sinan, 86150 Augsburg (DE); Horn, Siegfried, 86150 Ausgburg (DE); Sause, Markus, 86150 Augsburg (DE)
(74) Representative: Koplin, Moritz

(57) **Abstract**

Provided is a process for assessing physical properties of a para- or diamagnetic structure.

## Description

### FIELD

The present disclosure relates to the assessment of physical properties of a para- or diamagnetic structure. In particular, the present disclosure relates to the assessment of physical properties of carbon fibers.

### BACKGROUND

When manufacturing carbon fibers, small variations of the process parameters such as temperature, atmosphere, mechanical tension, etc. can have a large impact on the physical properties of the product. Thus, unless the process parameters are controlled with high accuracy, the physical properties of carbon fibers may easily differ from what was intended.

### SUMMARY

The present invention provides a method for assessing physical properties (including mechanical properties such as, for example, tensile/compressive/shear strength, modus of elasticity, elongation at break, hardness, density, etc.) of a para- or diamagnetic structure (e.g., a structure comprising one or more carbon fibers), a method of testing a quality of a carbon fiber, and an apparatus for carbon fiber manufacturing.

The method for assessing physical properties of a para- or diamagnetic structure comprises determining an interaction between the para- or diamagnetic structure and a magnetic field.

For example, a static or dynamic magnetic field may be used to induce a response of the para- or diamagnetic structure.

In this regard, the term "para- or diamagnetic structure", as used throughout the description and the claims, particularly refers to a structure formed of a material that exhibits para- or diamagnetic behavior which causes that the structure interacts with and is attracted/repelled by the magnetic field. In this regard, the term "interaction", as used throughout the description and the claims, particularly refers to the generation of an induced magnetic field by the para- or diamagnetic material of the para- or diamagnetic structure which overlays the magnetic field that caused it. For example, the interaction may be determined by measuring a change in magnetic field strength caused by the para- or diamagnetic structure in the magnetic field.

The method may further comprise exciting oscillations of the para- or diamagnetic structure.

In this regard, the term "oscillations", as used throughout the description and the claims, particularly refers to a reoccurring (periodic) displacement of (a part of) the para- or diamagnetic structure within the magnetic field. For example, the para- or diamagnetic structure may comprise one or more carbon fibers forming a strand that (if under tension) can be excited to vibrations showing a specific oscillatory pattern (e.g., a standing wave). Notably, the para- or diamagnetic structure may also be formed of a fabric, sheet or beam of a diamagnetic material such as, for example, graphite (comprising graphene layers).

The oscillations of the para- or diamagnetic structure may be excited by a sonic field.

For example, the para- or diamagnetic structure may be guided through a sonic field overlaid with the magnetic field such that the para- or diamagnetic structure is subject to pressure variations that cause a movement of (parts of) the para- or diamagnetic structure relative to the magnetic field.

The method may further comprise measuring an amplitude and/or a frequency of the oscillations.

The measured amplitude and/or frequency may be used to control the sonic field but may also be used to assess the mechanical properties of the para- or diamagnetic structure such as, for example, the modulus of elasticity.

The amplitude and/or the frequency of the oscillations may be measured by an optical, an electromechanical, a capacitive, an inductive or a resistive sensor.

For instance, the amplitude and/or the frequency of the oscillations may be measured by a camera or piezoelectric element in mechanical contact with the para- or diamagnetic structure.

The para- or diamagnetic structure may comprise a carbon fiber and the assessment of the physical properties of the carbon fiber may be employed for controlling a process of manufacturing carbon fibers. Notably, the carbon fiber may comprise single filaments and multi filament rovings, bundles or textiles dry, sized or impregnated.

For example, controlling the manufacturing process based on the assessed physical properties may comprise controlling one or more of a carbonizing temperature, a graphitizing temperature, a carbonizing duration, a graphitizing duration, a temperature gradient, a processing speed, an atmosphere, a tension, a rotation speed, and a pressure. Moreover, the composition of the material from which the carbon fiber is made may also be controlled based on the assessed physical properties.

Assessing the physical properties of the carbon fiber may comprise determining a deviation of the determined interaction from a reference interaction and changing parameters of the manufacturing process to reduce the deviation.

For instance, the interaction of a carbon fiber having suitable physical properties may be measured and used as a reference. Deviations may then be caused by local imperfections or by an unintended degradation of the manufacturing process.

Determined deviations may be used for (inline) quality control, wherein a carbon fiber causing a deviation that is above a threshold is repaired or rejected. For instance, a carbon fiber that causes a deviation that is above a threshold may be separated from carbon fibers causing a deviation that is below the threshold (and reworked or recycled).

In this regard, it is noted that assessing the physical properties of carbon fibers may also be used for classifying material that is to be recycled. This allows combining materials of similar physical properties or blending materials of different physical properties.

The assessing of physical properties of carbon fibers may be used in a method of sorting carbon fibers by assigning the carbon fibers to different grades in accordance with the assessed physical properties.

The method of testing a quality of a carbon fiber comprises placing a carbon fiber above a permanent magnet and assessing physical properties of the carbon fiber based on a distance at which the carbon fiber floats above the permanent magnet.

The carbon fiber manufacturing apparatus comprises a furnace and an inline quality control system downstream of the furnace, wherein the inline quality control system is configured to determine an interaction between a magnetic field and a para- or diamagnetic carbon fiber.

For example, the carbon fibers may be checked after being carbonized (in a carbonizing furnace) and/or after being graphitized (in a graphitizing furnace) to ensure that the physical properties meet predetermined requirements.

The inline quality control system may be configured to control an amplitude and/or a frequency of oscillations of the para- or diamagnetic carbon fiber by a sonic field that overlaps the magnetic field.

The sonic field may excite the para- or diamagnetic carbon fiber to oscillate within the magnetic field, thereby producing a characteristic footprint that depends (inter alia) on the density and the modus of elasticity of the fiber.

Notably, the interaction may also be determined while there is (only) a linear relative movement between the para- or diamagnetic carbon fiber and the magnetic field, or even no movement at all. This may come at the cost of producing a less characteristic footprint which may, however, still be suitable for a wide range of employment scenarios and in particular for the close-up inspection of local imperfections.

The inline quality control system may comprise a sensor which is configured to measure the amplitude and/or the frequency of the oscillations.

The inline quality control system may be further configured to control at least one of a carbonizing temperature, a graphitizing temperature, a carbonizing duration, a graphitizing duration, a temperature gradient, a processing speed, an atmosphere, a tension, a rotation speed, and a pressure, based on the determined interaction. Moreover, the inline quality control system may also be configured to control the composition of the material based on the determined interaction.

The inline quality control system may be further configured to base the control of the carbonizing and/or the graphitizing temperature and/or the carbonizing and/or the graphitizing duration on the measured amplitude and/or frequency of the oscillations.

The apparatus may further comprise a lock-in amplifier. For example, the lock-in amplifier may be tuned to the frequency of the oscillations.

It will be appreciated that the features and attendant advantages of the disclosed apparatus may be realized by the disclosed method and vice versa.

### BRIEF DESCRIPTION OF THE DRAWINGS

The foregoing aspects and many of the attendant advantages will become more readily appreciated as the same becomes better understood by reference to the following detailed description, when taken in conjunction with the accompanying drawings, wherein like reference numerals refer to like parts throughout the various views, unless otherwise specified.
Fig. 1 schematically illustrates components of a system for assessing the physical properties of a para- or diamagnetic structure;
Fig. 1a schematically illustrates a modification of the arrangement shown in Fig. 1, wherein the magnetic field strength is measured at multiple points;
Fig. 2 schematically illustrates a modification of the arrangement shown in Fig. 1, wherein a sonic field excites the para- or diamagnetic structure to oscillations;
Fig. 2a schematically illustrates a modification of the arrangement shown in Fig. 2, wherein the oscillations are measured by an optical sensor;
Fig. 2b schematically illustrates a modification of the arrangement shown in Fig. 2, wherein a current/voltage induced by the movement of the para- or diamagnetic structure is measured;
Fig. 3 schematically illustrates a modification of the arrangement shown in Fig. 1, wherein a magnetic field excites the para- or diamagnetic structure to oscillations;
Fig. 3a schematically illustrates a modification of the arrangement shown in Fig. 3, wherein the oscillations are measured by an optical sensor;
Fig. 3b schematically illustrates a modification of the arrangement shown in Fig. 3, wherein a current/voltage induced by the movement of the para- or diamagnetic structure is measured;
Fig. 4 schematically illustrates removing a part of a para- or diamagnetic structure suffering from a local imperfection;
Fig. 5 shows a flow-chart of a method for assessing physical properties of a para- or diamagnetic structure;
Fig. 6 schematically illustrates an employment scenario where components of the system shown in Fig. 1 to Fig. 3b are used in an apparatus for assessing the physical properties of carbon fibers;
Fig. 7 shows a flow-chart of a method of testing the quality of carbon fibers;
Fig. 8 illustrates the method of the flow-chart of Fig. 7;
Fig. 9 and Fig. 10 show graphs on the (molar) susceptibility of different materials; and
Fig. 11 shows a graph on the (mass) susceptibility of a material for different carbonizing temperatures; and
Fig. 12 shows a linear fit regarding the (mass) susceptibility per field strength.

Notably, the drawings are not drawn to scale and unless otherwise indicated, they are merely intended to conceptually illustrate the structures and procedures described herein.

### DETAILED DESCRIPTION

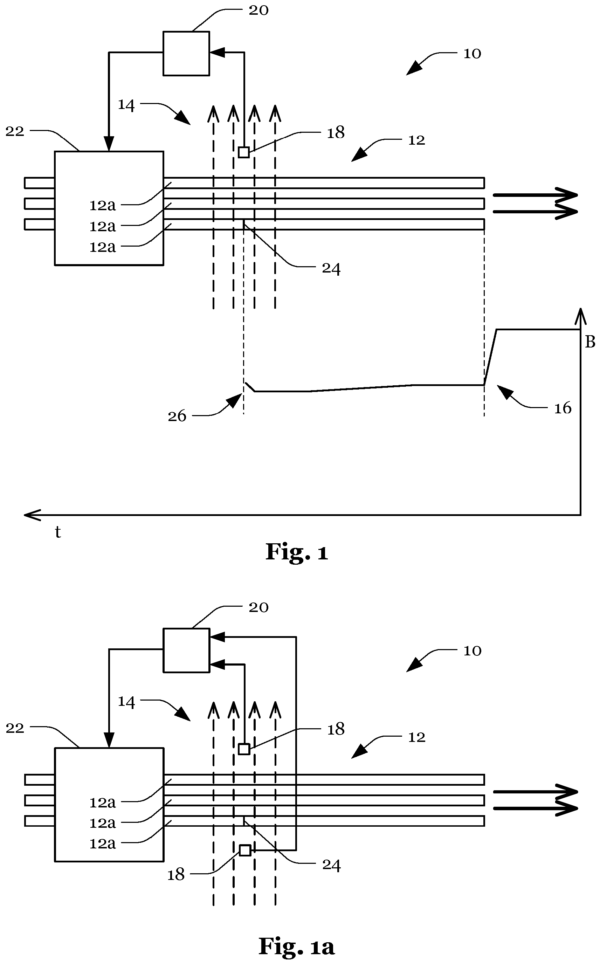

Fig. 1 schematically illustrates components of a system 10 for assessing the physical properties of a para- or diamagnetic structure 12 such as, for example, a para- or diamagnetic structure 12 comprising graphite (e.g., a single graphitized carbon fiber 12a, a strand/braid of graphitized carbon fibers 12a, etc.). This is because small variations of production parameters (temperature, tension, pressure, etc.) lead to considerable changes in the magnetic behavior of carbon fibers 12a (which may, for example, include a transition between paramagnetic and diamagnetic behavior). Thus, the magnetic behavior may be a precise indicator for the production parameters which also determine other physical properties (e.g., mechanical properties) which allows exploiting the magnetic behavior as a quality indicator. However, the invention is not limited to carbon fibers 12a but may also be used when it comes to other materials with a strong correlation between production parameters and magnetic behavior. In particular, the invention may be used for materials that experience a transition between paramagnetic and diamagnetic behavior as a result of inaccuracies in the production process.

The system 10 comprises a device which is configured to generate a (static or dynamic) magnetic field 14 (e.g., a permanent magnet and/or a spool). When the para- or diamagnetic structure 12 is placed within (or guided through) the magnetic field 14, a change 16 in the strength of the magnetic field 14 occurs which is due to the para- or diamagnetic behavior of para- or diamagnetic structure 12. As it has been found that the magnitude of the change 16 correlates with physical properties of the para- or diamagnetic structure 12, data on the measured magnetic field strength (which may be provided by a magnetic sensor 18) may be used for non-destructive (inline) quality monitoring/control.

For example, as illustrated in Fig. 1, data on the measured strength of the magnetic field 14 may be provided to a process control unit 20 and the process control unit 20 may take changes 16, 26 of the strength of the magnetic field 14 into account. For instance, if a change 16 of the strength of the magnetic field 14 occurs that (is caused by the para- or diamagnetic structure 12 but) differs from an expected change (which may be used as a reference), the process control unit 20 may adapt parameters of the manufacturing process.

For example, the process control unit 20 may adapt the graphitizing temperature, the graphitizing duration, the atmosphere, the temperature gradient, the processing speed, the tension, the rotation speed, or the pressure (in the graphitizing furnace 22) until the reference is met (or the change 16 is within a tolerance region around the reference). Notably, the process control unit 20 may also adapt other parameters of the manufacturing process such as, for example, the carbonizing temperature, the carbonizing duration, the atmosphere, the temperature gradient, the processing speed, the atmosphere, the tension, the rotation speed, and the pressure in a carbonizing furnace.

In a similar manner, the process control unit 20 may monitor the data on the measured strength of the magnetic field 14 provided by the sensor 18 to detect local imperfections 24. For example, when a graphitized carbon fiber 12a with a local imperfection 24 is exposed to the magnetic field 14, the local imperfection 24 may be detected by the change 26 in the measured magnetic field strength (i.e., the deviation from the expected strength of the magnetic field 14). Once detected, the local imperfection 24 may be repaired (if possible) or the affected graphitized carbon fiber 12a (or the part of the para- or diamagnetic structure 12 that comprises the affected portion of the graphitized carbon fiber 12a) may be removed.

As illustrated in Fig. 1a, the strength of the magnetic field 14 may be measured at different points/locations around the para- or diamagnetic structure 12 (e.g., by using a sensor array) to improve localization and/or for monitoring the homogeneity of the para- or diamagnetic structure 12. This may also be of particular interest if the para- or diamagnetic structure 12 is comprised of elements that are arranged in a particular pattern such as, for example, a para- or diamagnetic structure 12 formed of braided carbon fibers 12a. Notably, a para- or diamagnetic structure 12 comprised of elements that are arranged in a particular pattern (like a braid) may cause measurements that change periodically as the para- or diamagnetic structure 12 and the magnetic field 14 are moved relative to each other, such that instead of comparing or analyzing single measurements, it may be necessary to compare or analyze measurement patterns.

As described above, determining the interaction between the magnetic field 14 and the para- or diamagnetic structure 12 (e.g., by measuring the magnetic field strength at one or more locations in the vicinity of the para- or diamagnetic structure 12) may be used for both, process parameter control and imperfection localization to deliver products of homogeneous (and guaranteed) quality. However, the usage is not limited to process parameter control and imperfection localization.

Determining the interaction may also be employed when separating and/or ensuring the quality of recycled material of inhomogeneous/unknown quality or checking the quality of material that has been derived from (e.g., manufactured by) an unreliable process. Accordingly, although the components of the system 10 for assessing the physical properties of a para- or diamagnetic structure 12 as illustrated in Fig. 1 are described in the context of manufacturing carbon fibers 12a, they may also be used in other areas where the assessment of the physical properties of para- or diamagnetic structures 12 is required.

As illustrated in Fig. 1, assessing the physical properties of carbon fibers 12a may be performed inline, wherein the carbon fibers 12a drawn from the graphitizing furnace 22 (or the carbonizing furnace) are guided through the magnetic field 14 and the interaction that takes place may be continuously determined. Notably, the monitoring may also be performed step-wise with no relative movement between the carbon fibers 12 and the magnetic field 14 (when the measurement is made), or the device generating the magnetic field 14 and the sensor 18 may be moved along (e.g., parallel to) the stationary carbon fibers 12.

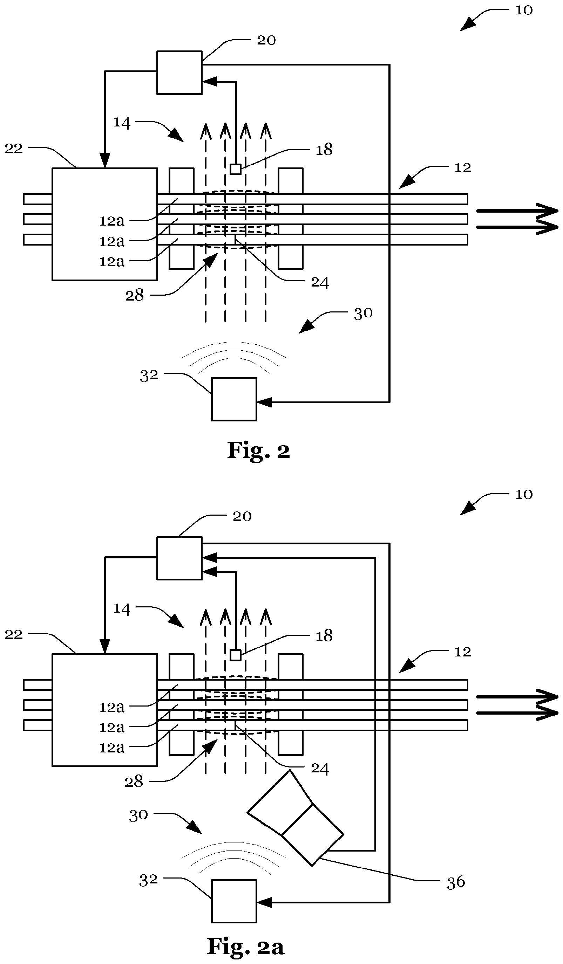

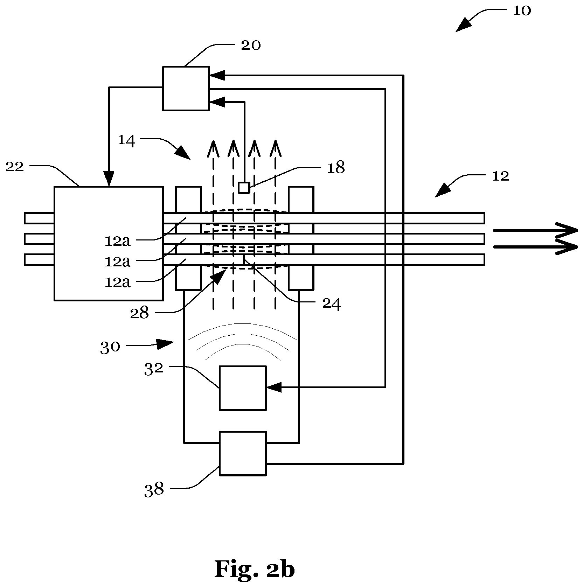

As illustrated in Fig. 2, the para- or diamagnetic structure 12 may be excited to oscillations 28 by generating a sonic field that overlays the magnetic field 14. For example, the system 10 may comprise a sonic wave generator 32 (e.g., a piezoelectric transducer) that emits (ultra-)sonic waves onto the para- or diamagnetic structure 12. The para- or diamagnetic structure 12 may be supported by two elements determining the length of the (strand of the) carbon fibers 12a that are excited to oscillations 28 and the wavelength of the (ultra-)sonic waves may be matched to a resonance frequency of the carbon fibers 12a. As the amplitude and the frequency of the oscillations 28 also depend on the physical (and in particular the mechanical) properties of the graphitized carbon fibers 12a, an imperfection 24 will cause a change 26 in the measured (pattern of the) magnetic field strength.

As illustrated in Fig. 2a, the amplitude and/or the frequency of the oscillations 28 may be measured by an optical sensor 36 or an electromechanical sensor (e.g., a piezoelectric sensor). The sensor data may be provided to the process control unit 20 and the process control unit 20 may use the provided data for controlling the manufacturing process. Notably, the measured amplitude and/or the frequency may also be used when assessing the physical properties of a para- or diamagnetic structure 12 for other purposes, as indicated above.

As illustrated in Fig. 2b, the current/voltage induced by the movement of the para- or diamagnetic structure 12 may be measured by a current/voltage sensor 38. Measuring the current/voltage induced by the movement of the para- or diamagnetic structure 12 may be performed alternatively or in addition to measuring the amplitude and/or the frequency of the oscillations 28 and may be used in a similar manner to assess the physical properties of the para- or diamagnetic structure 12. In both cases, the measurement data produced by a para- or diamagnetic structure 12 of known physical properties may be used as a reference and deviations from this reference may indicate a possible degradation.

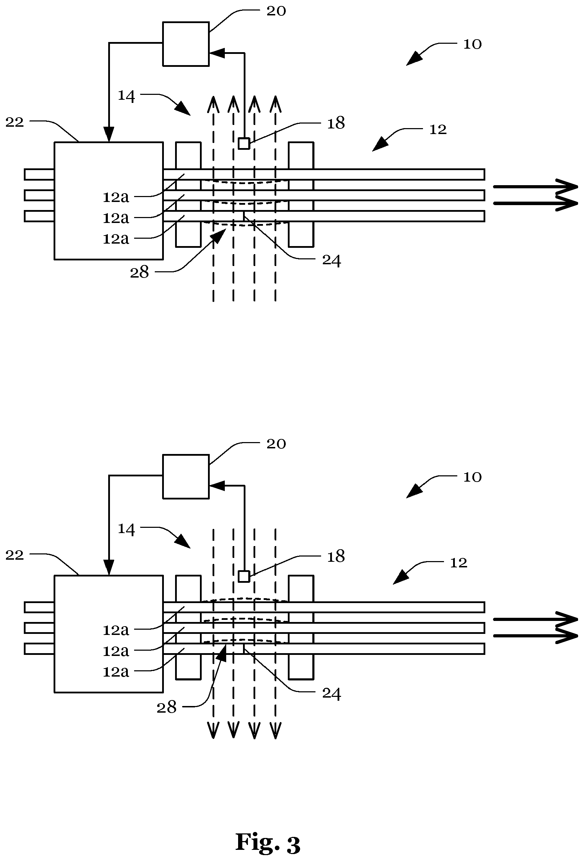

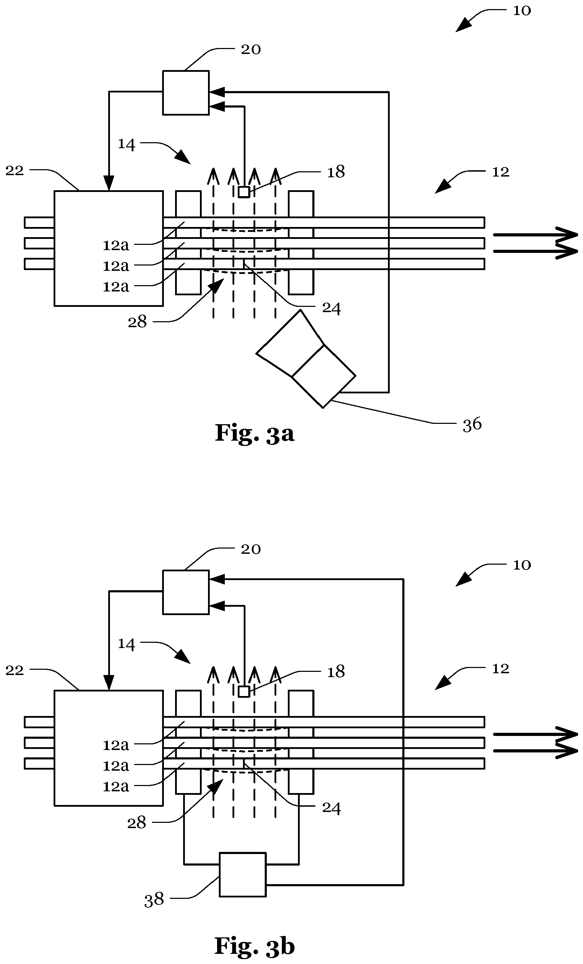

As illustrated in Fig. 3, the para- or diamagnetic structure 12 may also be excited to oscillations 28 by applying an alternating magnetic field 14 to the para- or diamagnetic structure 12. In this case, an imperfection 24 may reveal itself not only by a change 26 in the para- or diamagnetic behavior of the para- or diamagnetic structure 12 as described in relation to Fig. 1 and Fig. 1a, but also by a shift in the resonance frequency and/or the amplitude (which at least partially results from the change 26) that changes the frequency and/or the amplitude of the magnetic field strength oscillations measured over time. Due to this interaction, a para- or diamagnetic structure 12 is likely to have an even more characteristic footprint which is easily discernible from footprints of other para- or diamagnetic structures 12.

As illustrated in Fig. 3a and Fig. 3b, the system 10 may still measure the frequency and/or the amplitude of the oscillations 28 by an optical sensor 36, and the current/voltage induced by the movement of the para- or diamagnetic structure 12 by a current/voltage sensor 38. This may further improve the accuracy of the assessment because effects of imperfections 24 that (partially) compensate each other may be detected. In addition, a lock-in amplifier may be used to improve the accuracy of the detection.

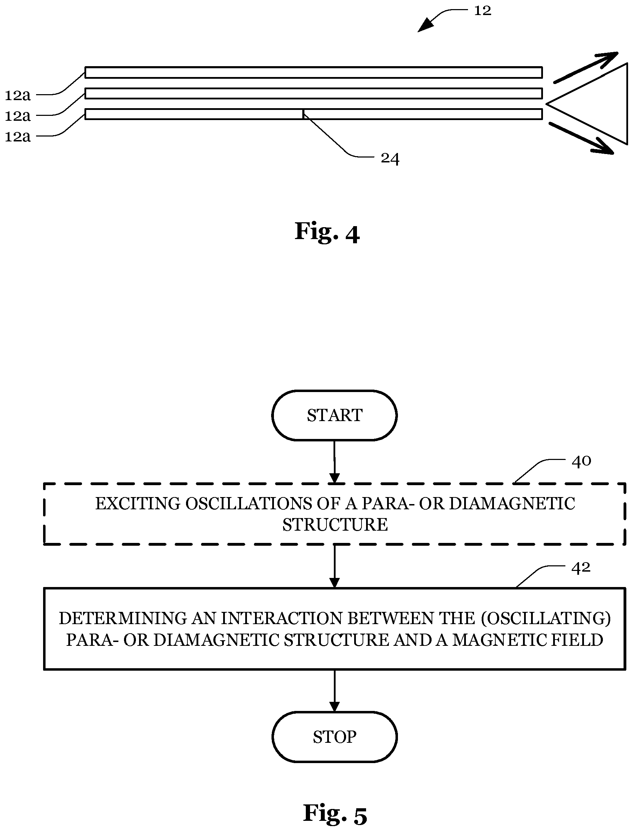

As illustrated in Fig. 4, a part of a para- or diamagnetic structure 12 suffering from a local imperfection 24 may be removed or repaired by reworking. Moreover, the detection of local imperfections 24 may also be used to assign a quality grade to the para- or diamagnetic structure 12. This avoids (unintentionally) employing para- or diamagnetic structures 12 below a certain quality grade and allows (intentionally) blending para- or diamagnetic structures 12 of different quality grades. In any case, the above described nondestructive and contact-free assessment of physical properties of para- or diamagnetic structures 12 reduces the effort of providing para- or diamagnetic structures 12 having predetermined physical properties.

Fig. 5 shows a flow-chart of the process described with reference to Fig. 2 to Fig. 3b. The process starts at step 40 by exciting oscillations 28 of the para- or diamagnetic structure 12. After exciting the oscillations 28, the process is continued at step 42 by determining the interaction between the oscillating para- or diamagnetic structure 12 and the magnetic field 14. As described above, the determined interaction correlates with the physical properties of the para- or diamagnetic structure 12 and hence allows to assess them. Notably, exciting the oscillations 28 may be particularly helpful to assess mechanical properties of the para- or diamagnetic structure 12, but the invention may also be practiced using a para- or diamagnetic structure 12 that does not oscillate in the magnetic field 14.

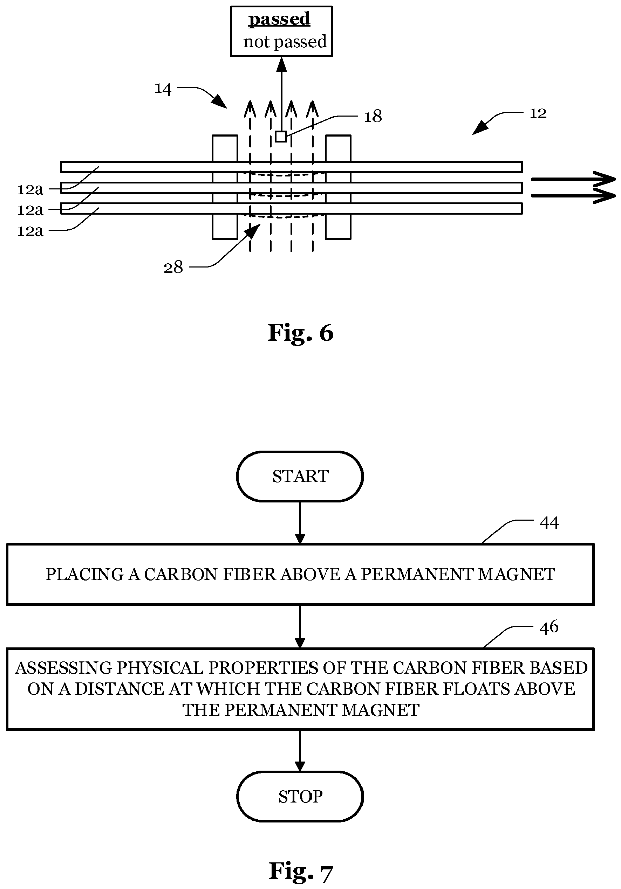

In another example shown in Fig. 6, the device generating the magnetic field 14 and the sensor 18 may be used in an apparatus for assessing the physical properties of carbon fibers 12a. While the working principle (and the possible modifications) are the same as the ones described with reference to Fig. 1 to Fig. 3b, the assessment may not be used to control process parameters and localize imperfections but, as mentioned above, for non-destructive testing regarding whether the overall quality of the tested material is acceptable. For example, the tested structure 12 may not pass the test if a spread between the carbon fibers 12a is too large/too small or if the mechanical properties of the carbon fibers 12a are not suitable for the envisaged use.

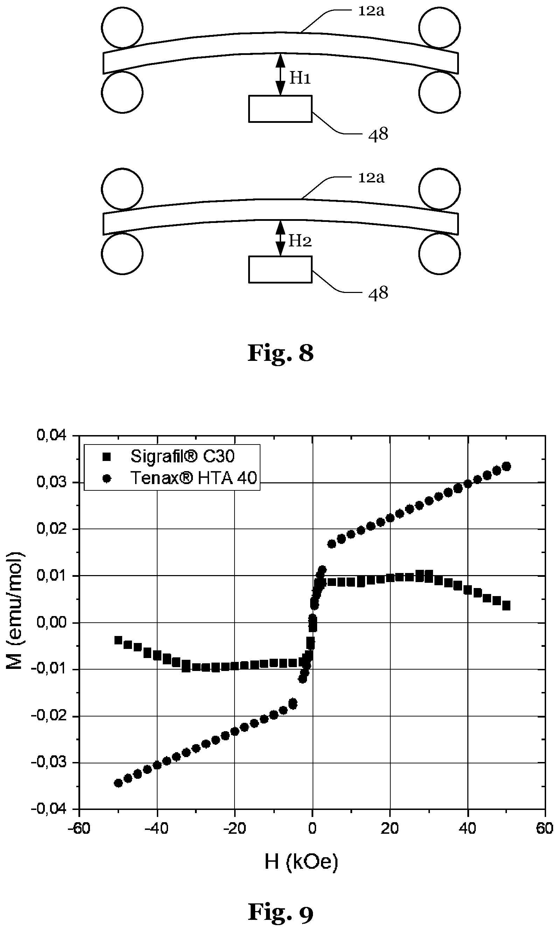

Fig. 7 shows a flow-chart of a process of testing a quality of a carbon fiber 12a. The process comprises a step 44 of placing a carbon fiber 12a above a permanent magnet 48 as illustrated in Fig. 8 and assessing physical properties of the carbon fiber 12a based on a distance Hi, H2 at which the carbon fiber 12a floats above the permanent magnet 48.

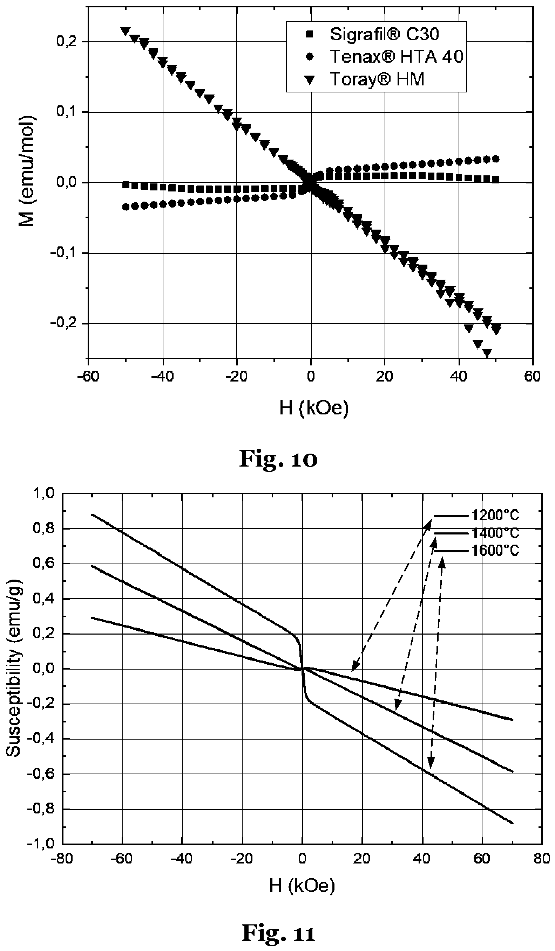

Fig. 9 and Fig. 10 show graphs on the (molar) susceptibility of different materials:

**Table 1: Material Properties**

| Material | Tensile Strength | Tensile Modulus of Elasticity | Density |
|---|---|---|---|
| Sigrafil ® C30 | 4000 MPa | 240 GPa | 1.8 g/cm³ |
| Tenax ® HTA 40 | 4100 MPa | 240 GPa | 1.77 g/cm³ |
| Toray ® HM | 3920 MPa | 588 GPa | 1.93 g/cm³ |

As can be seen from the graphs, the different materials are well discernable by determining their interaction with a magnetic field.

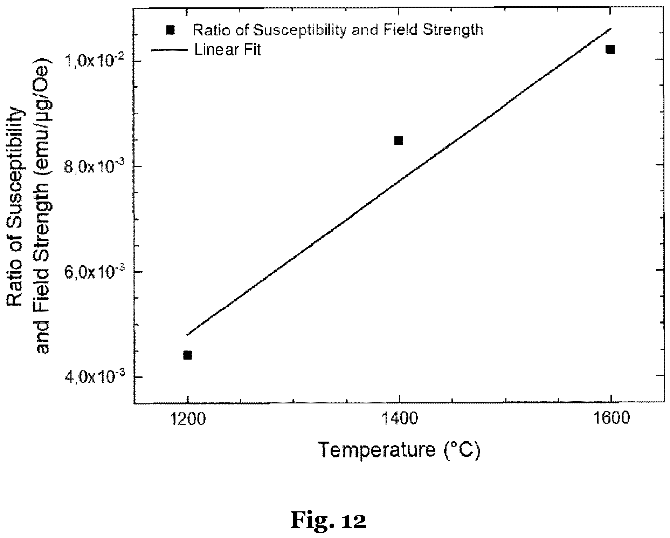

Fig. 11 shows a graph on the (mass) susceptibility of a material for different carbonizing temperatures. As can be seen from the graph, different carbonizing temperatures are well discernable by determining the interaction of the carbonized material with a magnetic field. Moreover, as can be seen from Fig. 12, the ratios of the (mass) susceptibility and the field strength show a linear dependency as regards the temperature, such that different materials are likely to be discernible by their slope.

### LIST OF REFERENCE NUMERALS

- 10: system
- 12: para- or diamagnetic structure
- 12a: carbon fiber
- 14: magnetic field
- 16: change (in the measured magnetic field strength)
- 18: sensor
- 20: process control unit
- 22: graphitizing furnace
- 24: local imperfection
- 26: change (in the measured magnetic field strength)
- 28: oscillations
- 30: sonic field
- 32: sonic wave generator
- 34: support element
- 36: optical sensor
- 38: current/voltage sensor
- 40: process step
- 42: process step
- 44: process step
- 46: process step
- 48: permanent magnet

## Claims

**1.** A method for assessing physical properties of a para- or diamagnetic structure (12), the method comprising:
determining (42) an interaction between the para- or diamagnetic structure (12) and a magnetic field (14).

**3.** The method of claim 2, wherein the oscillations (28) of the para- or diamagnetic structure (12) are excited by a sonic field (30).

**4.** The method of claim 2 or 3, further comprising:
measuring an amplitude and/or a frequency of the oscillations (28).

**5.** The method of claim 4, wherein the amplitude and/or the frequency of the oscillations (28) are measured by an optical, an electromechanical, a capacitive, an inductive or a resistive sensor (18).

**6.** The method of any one of claims 1 to 5, wherein the para- or diamagnetic structure (12) comprises a carbon fiber (12a).

**7.** A method of controlling a process of manufacturing carbon fibers (12a), the method comprising:
assessing physical properties of a carbon fiber (12a) according to claim 6; and
controlling the manufacturing process based on the assessed physical properties.

**8.** The method of claim 7, wherein controlling the manufacturing process based on the assessed physical properties comprises controlling one or more of a carbonizing temperature, a graphitizing temperature, a carbonizing duration, a graphitizing duration, a temperature gradient, a processing speed, an atmosphere, a tension, a rotation speed, and a pressure.

**9.** The method of claim 7 or 8, wherein assessing the physical properties of the carbon fiber (12a) comprises determining a deviation of the determined interaction from a reference interaction and changing parameters of the manufacturing process to reduce the deviation.

**10.** An inline quality control method, comprising:
controlling a process of manufacturing a carbon fiber (12a) according to claim 9; and
repairing or rejecting the carbon fiber (12a) if it causes a deviation that is above a threshold.

**11.** A method of sorting carbon fibers (12a), the method comprising:
assessing physical properties of carbon fibers (12a) according to claim 6; and
assigning the carbon fibers (12a) to different grades in accordance with the assessed physical properties.

**12.** A method of testing a quality of a carbon fiber (12a), the method comprising:
placing a carbon fiber (12a) above a permanent magnet; and
assessing physical properties of the carbon fiber (12a) based on a distance at which the carbon fiber (12a) floats above the permanent magnet.

**13.** A carbon fiber manufacturing apparatus, comprising:
a furnace (22); and
an inline quality control system (10) downstream of the furnace (22);
wherein the inline quality control system (10) is configured to determine an interaction between a magnetic field (14) and a para- or diamagnetic carbon fiber (12a).

**14.** The apparatus of claim 13, wherein the inline quality control system (10) is configured to control an amplitude and/or a frequency of oscillations (28) of the para- or diamagnetic carbon fiber (12a) by a sonic field (30) that overlaps the magnetic field (14).

**15.** The apparatus of claim 14, wherein the inline quality control system (10) comprises a sensor (36) which is configured to measure the amplitude and/or the frequency of the oscillations (28).

**16.** The apparatus of claim 13, wherein the inline quality control system (10) is further configured to control at least one of a carbonizing temperature, a graphitizing temperature, a carbonizing duration, a graphitizing duration, a temperature gradient, a processing speed, an atmosphere, a tension, a rotation speed, and a pressure, based on the determined interaction.

**17.** The apparatus of claim 16, wherein the inline quality control system (10) is further configured to base the control of the carbonizing and/or the graphitizing temperature and/or the carbonizing and/or the graphitizing duration on the measured amplitude and/or frequency of the oscillations (28).

**18.** The apparatus of any one of claims 13 to 17, further comprising a lock-in amplifier.
